# EUROPÄISCHE PATENTSCHRIFT

(11) **EP 0 495 785 B1**
(45) Veröffentlichungstag und Bekanntmachung des Hinweises auf die Patenterteilung: **07.12.1994**
(21) Anmeldenummer: 90912027.1
(22) Anmeldetag: 10.08.1990
(51) Int. Cl.: B41J 29/02, H05K 7/16, F16C 11/04

(54) **DRUCKEINRICHTUNG**
PRINTER
IMPRIMANTE

(30) Priorität: 13.10.1989 DE 3934320
(43) Veröffentlichungstag der Anmeldung: 29.07.1992
(73) Patentinhaber: EASTMAN KODAK COMPANY, Rochester, New York 14650 (US)
(72) Erfinder: BÖHMER, Georg, D-8000 München 60 (DE); IRRO, Otmar, D-8152 Feldkirchen-Westerham (DE)
(74) Vertreter: Pohle, Reinhard, Dipl.-Phys.
(86) Internationale Anmeldenummer: DE9000619
(87) Internationale Veröffentlichungsnummer: WO9105667

(56) Entgegenhaltungen:
- EP-A- 0 001 752
- EP-A- 0 020 866
- EP-A- 0 226 326
- DE-U- 1 812 660
- US-A- 3 288 500
- US-A- 4 161 017
- US-A- 4 848 941
- PATENT ABSTRACTS OF JAPAN, vol. 11, no. 105 (M-577)(2552) 3 April 1987; JP A 61 252 181; (H. HIRANO) 10.11.1986

## Beschreibung

Die Erfindung betrifft eine Druckeinrichtung gemäß dem Oberbegriff des Patentanspruchs 1.

Für einen ergonomischen Aufbau einer Druckeinrichtung, beispielsweise eines Tintendruckers, sollten sowohl Druckerbock als auch elektronische Flachbaugruppen der Druckeinrichtung möglichst montagegünstig und servicefreundlich in ein Druckergehäuse, beispielsweise aus Kunststoff, eingebaut werden. Unter einer elektronischen Flachbaugruppe soll dabei beispielsweise eine gedruckte Schaltungsplatine oder Leiterplatte verstanden werden, die zur Stromversorgung und Steuerung von Funktionsabläufen in der Druckeinrichtung und speziell in dem Druckerbock mit elektronischen Bauteilen bestückt ist. Wenn im folgenden von einem Druckerbock die Rede ist, so ist damit ein Sitz- und Stützgestell für mechansiche und elektrische Baugruppen der Druckeinrichtung gemeint. Zu den mechanischen und elektrischen Baugruppen gehören beispielsweise ein Druckerwagen, eine Schreibwalze, ein Getriebe, ein Schrittmotor etc.

Eine Einbaumöglichkeit besteht darin, daß der Druckerbock über Gummipuffer in eine Gehäusebodenwanne eingesteckt wird. Dies hat jedoch den Nachteil, daß die vorzugsweise an der Unterseite des Druckerbocks befestigten Leiterplatten für Montage, Service und Prüfung nur schwer zugänglich sind.

Eine weitere Einbaumöglichkeit ist aus der Siemens-Übersichtsbeschreibung für einen Fernschreiber 1000 S vom Oktober 1979 bekannt. In dieser Übersichtsbeschreibung ist auf der Seite 3-1 der Fernschreiber in einer Servicestellung abgebildet. Charakteristisch für die Servicestellung ist ein von einem Gehäuseboden weggeschwenkter, durch ein Stützelement abgestützter Druckerbock. Durch den weggeschwenkten Druckerbock ist eine auf dem Gehäuseboden befindliche, mit elektronischen Bauteilen bestückte Leiterplatte für Montage- und Wartungsarbeiten frei zugänglich.

Weitere Druckeinrichtungen der genannten Art sind aus der US-A-4,531,852 und dem DE-GM 81 06 810 bekannt.

Die EP-A2-0 226 326 beschreibt eine Druckeinrichtung mit einem Gehäuseboden und einem zu diesem verschwenkbaren Gehäuseoberteil zur Aufnahme von Baugruppen. Die Baugruppen sind nur gemeinsam mit dem Gehäuseoberteil verschwenkbar. Im aufgeschwenkten Zustand stützt sich das Gehäuseoberteil selbst unmittelbar an dem Gehäuseboden ab und ermöglicht eine gute Zugänglichkeit einer zwischen dem Gehäuseboden und dem Gehäuseoberteil angeordneten Papiervorschub-Einrichtung. In dem Gehäuseoberteil angeordnete Baugruppen sind jedoch auch im aufgeschwenkten Zustand nur schwer zugänglich.

Aus der US-PS 4,848,941 ist eine gattungsgemäße Druckeinrichtung der eingangs genannten Art bekannt, die einen Gehäuseboden, ein Gehäuseoberteil mit einer Gehäuseklappe und einen Druckerbock umfaßt. Der eine Papiertransporteinrichtung tragende Druckerbock ist in eine Serviceposition verschwenkbar, um bei gleichzeitig entferntem Gehäuseoberteil eine Farbbandkassette einfach auswechseln zu können. Der Druckerbock ist in der Serviceposition nicht abgestützt, sondern muß durch eine externe Vorrichtung oder manuell gehalten werden. Die übrigen Baugruppen (z. B. der Druckkopf) sind auch bei verschwenktem Druckbock nur einseitig und schwer zugänglich.

Die Aufgabe der vorliegenden Erfindung liegt daher in der Schaffung einer Druckeinrichtung, deren Baugruppen zu Montage- und Wartungszwecken ohne externe Abstützmittel einfach zugänglich sind.

Diese Aufgabe wird durch die in dem Patentanspruch 1 angegebenen Merkmale gelöst.

Vorteilhafte Ausführungsformen der Erfindung sind in den Unteransprüchen angegeben.

Durch die schwenkbare Lagerung eines Druckerbockes in einem Druckergehäuse einer Druckeinrichtung, beispielsweise einem Tintendrucker, ist der Druckerbock an jeder Seite für Montage, Service und Prüfung frei zugänglich. Eine für die schwenkbare Lagerung vorgesehen Halterung ist dabei wegen des hohen Druckerbockgewichtes von ca. 7 kg vorzugsweise in einer Gehäusebodenwanne angeordnet. Als Betriebsposition für den Druckerbock ist weiterhin eine Auflage für den frei schwenkbaren Teil des Druckerbockes vorgesehen, die auch vorzugsweise in der Gehäusebodenwanne angeordnet ist.

Damit der schwenkbar gelagerte Druckerbock bei Montage- und Wartungsarbeiten der Druckeinrichtung nicht in einer Serviceposition manuell gehalten werden muß, ist im Aufbau der Druckeinrichtung eine Stütze vorgesehen. Als Stütze wird dabei vorteilhafterweise eine ebenfalls schwenkbar gelagerte Gehäuseklappe des Druckergehäuses verwendet. Dies hat den Vorteil, daß keine externe Stützvorrichtung bereitgestellt werden muß. Durch das Zusammenwirken von Halterung, Auflage und Gehäuseklappe wird bei der Serienmontage der Druckeinrichtung weiterhin eine aufwendige Drehvorrichtung, die das hohe Druckerbockgewicht aufnehmen kann, vermieden. Darüber hinaus gewährleistet das Zusammenwirken der Halterung, der Auflage und der Gehäuseklappe eine platzsparende Anordnung der Druckeinrichtung im Servicefall. Dieses wirkt sich dann vorteilhaft aus, wenn der Platz für Wartungsarbeiten beim Kunden begrenzt ist.

Um den Druckerbock möglichst einfach mit der Gehäusebodenwanne verankern zu können, weist der Druckerbock zwei die Schwenkachse bildende Lagerzapfen auf, die in der mit Rastvorsprüngen versehenen Halterung lösbar verrastet sind.

Um weiterhin gegen auftretende Stoßbelastungen geschützt zu sein, ist auf den Lagerzapfen eine Gummihülse gestülpt, die darüber hinaus zur Aufnahme von Axialkräften bei den Stoßbelastungen mit einem die Pufferwirkung verstärkenden radial vorspringenden Kranz versehen ist.

Durch die schwenkbare Lagerung des Druckerbockes in dem Druckergehäuse können die an der Unterseite des Druckerbockes befindlichen Leiterplatten nach oben geklappt werden. Damit auch die elektronischen Bauteile auf den Leiterplatten frei zugänglich sind, ist die Leiterplatte in einem Scharniergelenk schwenkbar angeordnet und mit einem vorzugsweise als unverlierbare Schraube ausgebildeten Befestigungselement an der Unterseite des Druckerbockes befestigbar.

Ein Ausführungsbeispiel der Erfindung ist anhand der Zeichnungen von Figur 1 bis Figur 8 erläutert. Es zeigen:
Figur 1 bis Figur 3 in einem Längsschnitt durch eine Druckeinrichtung verschiedene Servicestellungen der Druckeinrichtung,
Figur 4 und 5 in einem Längs- bzw. Querschnitt eine erste Ausführungsform eines Schwenkbereiches für einen Druckerbock in der Druckeinrichtung nach Figur 1,
Figur 6 in einem Längsschnitt eine zweite Ausführungsform des Schwenkbereiches für den Druckerbock in der Druckeinrichtung nach Figur 1,
Figur 7 einen Schnitt durch eine Befestigungsvorrichtung für Leiterplatten.

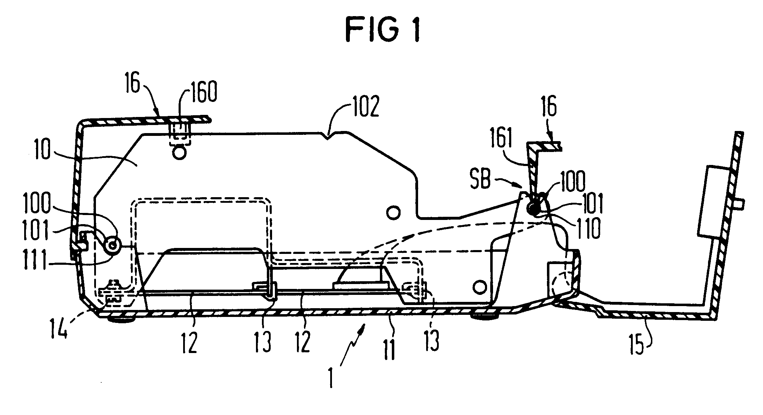

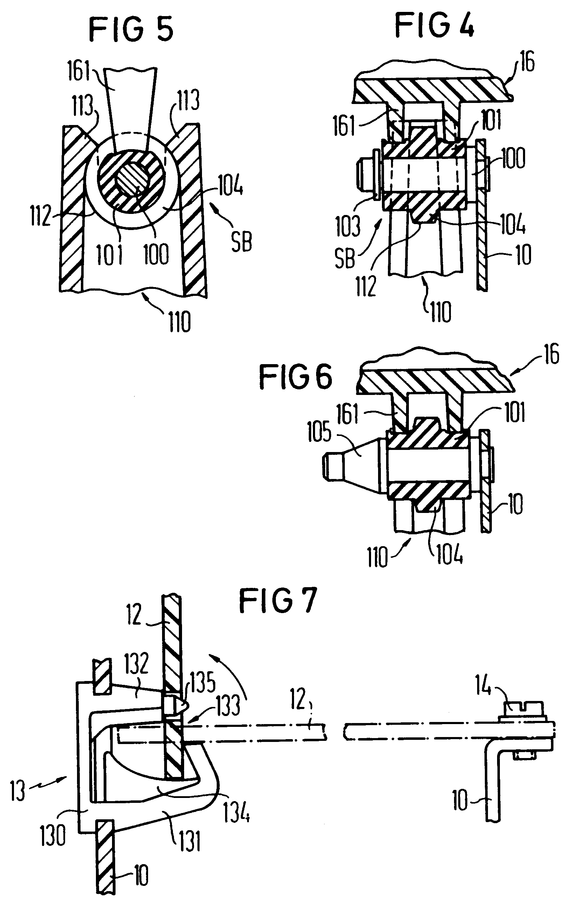

Die Figuren 1 bis 3 zeigen verschiedene Servicestellungen einer Druckeinrichtung 1. Charakteristisch für die Druckeinrichtung 1 ist ein Druckerbock 10, der in einem Schwenkbereich SB mit einem Ende in einer Halterung 110 einer Gehäusebodenwanne 11 schwenkbar gelagert ist. Die Lagerung des Druckerbocks 10 erfolgt dabei über zwei Lagerzapfen 100, die in dem Druckerbock 10 seitlich vorspringend verankert sind. Zur Aufnahme von Axialkräften bei auftretenden Stoßbelastungen auf dem Druckerbock 10 sind die Lagerzapfen 100 von einer Gummihülse 101 umgeben, die hierfür, wie bei der Beschreibung der Figur 4 bis 6 erläutert, speziell ausgebildet ist. Der Halterung 110 gegenüberliegend ist in der Gehäusebodenwanne 11 weiterhin eine Mulde 111 angeordnet, die als Auflage für das frei schwenkbare Ende des Druckerbockes 10 in einer Betriebsposition dient.

Der Druckerbock 10 weist außerdem noch Leiterplatten 12 auf, die Jeweils mit einer Befestigungsvorrichtung 13, 14, bestehend aus einem Scharniergelenk 13 und einer Befestigungsschraube 14, auf der Unterseite des Druckerbockes 10 befestigt werden. Die Befestigungsschraube 14 ist dabei vorzugsweise als unverlierbare Schraube ausgebildet.

Darüber hinaus wird der in der Gehäusebodenwanne 11 eingebaute Druckerbock 10 gegen Staub und sonstige Verunreinigungen durch eine Gehäuseklappe 15 und eine Gehäusekappe 16 geschützt. Die Gehäuseklappe 15 ist dabei an einem Ende dem Fußpunkt der Halterung 110 in der Gehäusebodenwanne 11 schwenkbar gelagert.

Wie auf der gegenüberliegenden Seite, so sind auch hier, für die Auflage des Druckerbockes 10, die Lagerzapfen 100 mit der jeweils umgebenden Gummihülse 101 seitlich vorspringend in den Druckerbock 10 verankert.

Die Figur 1 zeigt im einzelnen, in einer ersten Servicestellung der Druckeinrichtung 1 die auf dem Druckerbock 10 bzw. der Gehäusebodenwanne 11 angeordnete bzw. befestigte Gehäusekappe 16 sowie die von der Druckeinrichtung 1 weggeschwenkte Gehäuseklappe 15. Die Gehäusekappe 16 weist dazu einen Gumminoppen 160 und eine Rippe 161 auf, die beim Verrasten der Gehäusekappe 16 an der Gehäusebodenwanne 11 auf den Druckerbock 10 bzw. auf die den Lagerzapfen 100 umgebende Gummihülse 101 gedrückt werden und somit der Druckerbock 10 erschütterungsfrei in der Gehäusebodenwanne 11 angeordnet ist.

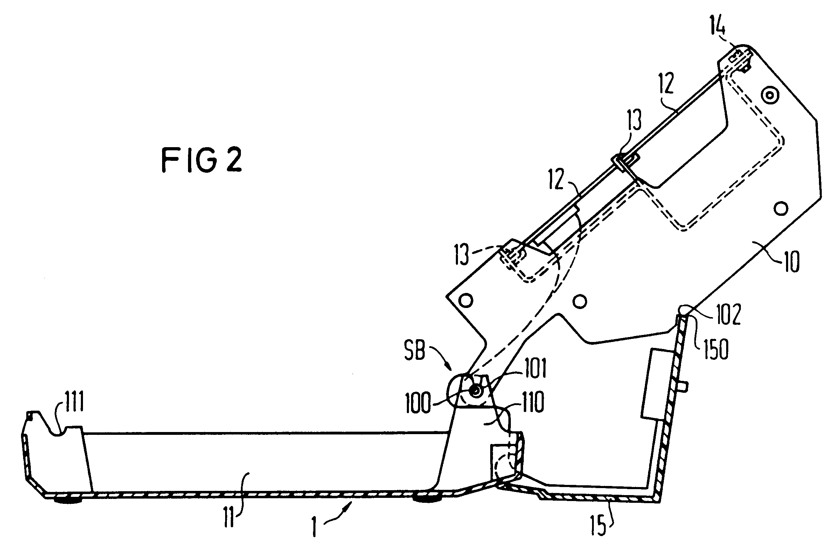

Die Figur 2 zeigt im einzelnen, in einer zweiten Servicestellung der Druckeinrichtung 1, wie der Druckerbock 10 nach Entfernen der Gehäusekappe 16 beispielsweise für Montage- und Wartungsarbeiten geschwenkt worden ist und sich dabei gegen die weggeklappte Gehäuseklappe 15 abstützt. Im Unterschied zur Figur 1, wo der Druckerbock 10 sich in der Betriebsposition befindet, ist er nun folgerichtig in einer Montage- und Wartungsposition. Um ein sicheres Abstützen des Druckerbockes 10 gegen die Gehäuseklappe 15 zu gewährleisten, ist in den Druckerbock 10 eine sich über die gesamte Druckerbockbreite erstreckende Kerbe 102 eingelassen, in die eine Kante 150 der abgeschwenkten Gehäuseklappe 15 eintaucht.

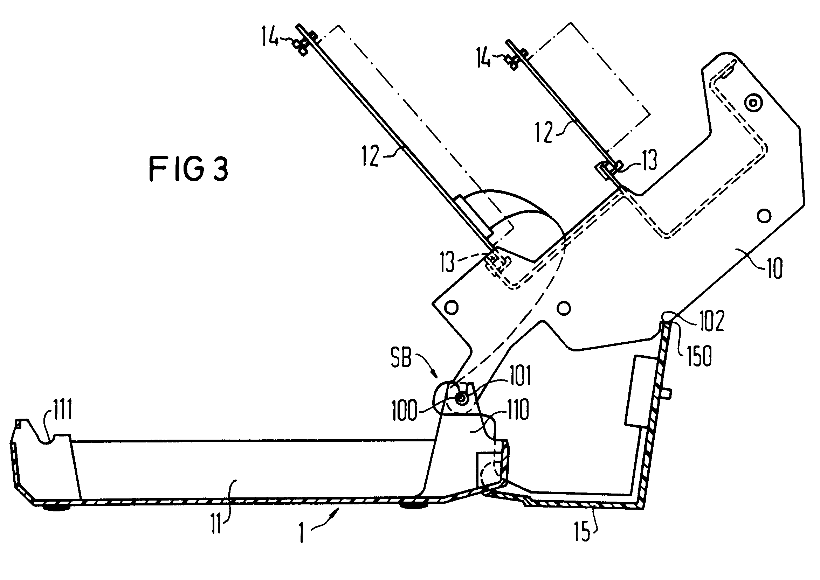

Die Figur 3 zeigt im einzelnen, in einer dritten Servicestellung der Druckeinrichtung 1, wie die an der Unterseite des Druckerbocks 10 befestigten Leiterplatten 12 in der Montage- und Wartungsposition des Druckerbocks 10 von diesem weggeschwenkt sind. Um die mit Hilfe des Scharniergelenkes 13 und der Befestigungsschraube 14 an den Druckerbock befestigte Leiterplatte 12 ebenfalls in eine Montage- und Wartungsposition bringen zu können, werden die Befestigungsschrauben 14 gelöst und die in den Scharniergelenken 13 angeordneten Leiterplatten 12 geschwenkt. Während das Scharniergelenk 13 im angeschraubten Zustand der Leiterplatte 12 die Fixierung der Leiterplatte 12 in einer Befestigungsebene parallel zum Drukkerbock 10 gemäß Figur 1 und 2 unterstützt, muß es im abgeschwenkten Zustand der Leiterplatte 12 diese in einer Abkippebene senkrecht zum Druckerbock 10 halten, ohne daß dabei die Leiterplatte 12 aus dem Scharniergelenk 13 herausfällt. Wie das Scharniergelenk 13 hierfür im einzelnen ausgebildet ist, wird anhand der Beschreibung der Figur 7 erläutert.

Die Figur 4 zeigt in einem Längsschnitt einer ersten Ausführungsform des Schwenkbereiches SB, wie der in dem Druckerbock 10 verankerte Lagerzapfen 100 mit der aufgeschobenen und durch einen Sicherungsring 103 gegen axiales Verrutschen geschützten Gummihülse 101 in der Halterung 110 verrastet ist. Um die auftretenden Axialkräfte bei Stoßbelastungen besser aufnehmen zu können, weist die Gummihülse 101 in der Mitte einen radial vorspringenden Kranz 104 auf, der durch die Rippen 161 der Gehäusekappe 16 noch zusätzlich gegen eine Lagerschale 112 der Halterung 110 gepreßt wird.

Die Figur 5 zeigt in einem Querschnitt des Schwenkbereiches SB gemäß der Figur 4, wie der Lagerzapfen 100 mit der Gummihülse 101 und dem Kranz 104 in der Lagerschale 112 der Halterung 110 verrastet ist. Damit der von der Gummihülse 101 umgebene Lagerzapfen 100 beim Schwenken des Druckerbockes 10 nicht aus der Halterung 110 herausgehoben wird, weist die Halterung 110 zwei sich gegenüberliegende, in den Schwenkbereich SB des Druckerbockes 10 hineinragende Rastvorsprünge 113 auf. Die unelastisch ausgebildeten Rastvorsprünge 113 müssen beim Montieren des Druckerbockes 10 überwunden werden. Dies geschieht dadurch, daß der Kranz 104 der Gummihülse 101 beim ruckartigen Hineindrücken des Lagerzapfens 100 in die Halterung 110 zusammengedrückt wird.

Die Figur 6 zeigt in einem Längsschnitt einer zweiten Ausführungsform des Schwenkbereichs SB, wie die Gummihülse 101 mit dem Kranz 104 auf einen Lagerzapfen 105 aufgeschoben ist, der zur Sicherung der Gummihülse 101 an dem dem Druckerbock 10 gegenüberliegenden Ende konusförmig ausgebildet ist.

Die Figur 7 zeigt in einer Seitenansicht, wie die Leiterplatte 12 in dem Scharniergelenk 13 schwenkbar angeordnet und mit der Befestigungsschraube 14 in einer Betriebsposition an den Druckerbock 10 befestigt ist. Das als Kunststoffspritzteil ausgebildete Scharniergelenk 13 besteht aus einer quadratischen Grundplatte 130, auf der an zwei gegenüberliegenden Seiten ein von der Kante der Grundplatte 130 abgesetztes, vorspringendes erstes Formteil 131 bzw. zweites Formteil 132 angeordnet ist. Das erste leicht schräg vorspringende Formteil 131 ist am freien Ende rechtwinklig zum zweiten Formteil 132 hin umgebogen und bildet dabei mit diesem einen Öffnungsspalt 133 für die Leiterplatte 12. Auf der Innenfläche des ersten Formteils 131 ist in einem Abstand x von der Grundplatte 130 eine rampenförmig ausgebildete, zum freien Ende des ersten Formteils 131 flacher werdende Erhebung 134 mittig angeordnet. Auf der Stirnfläche des zweiten Formteils 132 ist weiterhin ein vorspringender Dorn 135 angeordnet. Zur Aufnahme der Leiterplatte 12 wird das Scharniergelenk 13 in eine Öffnung 106 des Druckerbockes 10 gedrückt und verrastet. Hierfür ist auf der Außenfläche des ersten und zweiten Formteils 131, 132 zwischen der Grundplatte 130 und einer Einführschräge 136 eine Vertiefung 137 vorgesehen, in die die Öffnungskante der Öffnung 106 eingreift.

In der Betriebsposition der Leiterplatte 12 wird diese durch eine Stützpunktberührung sowohl mit dem ersten Formteil 131 als auch mit dem zweiten Formteil 132 in dem Scharniergelenk 13 festgeklemmt.

In der Montage- und Wartungsposition der Leiterplatte 12, bei der diese in der eingezeichneten Pfeilrichtung bewegt wird, rutscht die Leiterplatte 12 über die rampenförmige Erhebung 134 gegen das rechtwinklig umgebogene Formteil 131. Gleichzeitig dazu taucht der Dorn 135 in eine Bohrung 120 der Leiterplatte 12 ein, um ein Herausfallen der Leiterplatte 12 aus dem Scharniergelenk 13 zu verhindern.

### Bezugszeichenliste

- 1: Druckeinrichtung
- 10: Druckerbock
- 11: Gehäusebodenwanne
- 12: Leiterplatte, Schaltungsplatine
- 13: Scharniergelenk
- 14: Befestigungselement, Befestigungsschraube
- 15: Gehäuseklappe
- 16: Gehäusekappe
- 100, 105: Lagerzapfen
- 101: Gummihülse
- 102: Kerbe
- 103: Sicherungsring
- 104: radial vorspringender Kranz der Gummihülse
- 110: Halterung
- 111: Mulde, Auflage
- 112: Lagerschale
- 113: Rastvorsprung
- 120: Bohrung
- 130: Grundplatte
- 131: erstes Formteil
- 132: zweites Formteil
- 133: Öffnungsspalt
- 134: rampenförmige Erhebung
- 135: Dorn
- 150: Kante der Gehäuseklappe
- 160: Gumminoppen
- 161: Rippe
- SB: Schwenkbereich des Druckerbockes
- x: Abstand zwischen der Grundplatte und der rampenförmigen Erhebung

## Patentansprüche

1. Druckeinrichtung mit einem Gehäuseboden (11), einem dem Gehäuseboden (11) zugeordneten Gehäuseoberteil (15, 16) und einem separaten, Baugruppen der Druckeinrichtung (1) aufnehmenden Druckerbock (10), der in einer auf dem Gehäuseboden (11) angeordneten Halterung (110) schwenkbar gelagert ist, wobei das Gehäuseoberteil (15, 16) eine Gehäuseklappe (15) aufweist, **dadurch gekennzeichnet, daß** die Gehäuseklappe (15) auf dem Gehäuseboden (11) unabhängig von dem Druckerbock (10) schwenkbar angeordnet ist und daß die Gehäuseklappe (15) den bei Montage und Wartung der Druckeinrichtung (1) von dem Gehäuseboden (11) weggeschwenkten Druckerbock (10) abstützt.

2. Druckeinrichtung nach Anspruch 1, **dadurch gekennzeichnet,** daß der Druckerbock (10) Leiterplatten (12) aufweist, die bei Montage und Wartung der Druckeinrichtung (1) im abgeschwenkten Zustand des Druckerbocks (10) frei zugänglich sind.

3. Druckeinrichtung nach Anspruch 2, **dadurch gekennzeichnet,** daß die Leiterplatten (12) auf dem Druckerbock (10) schwenkbar angeordnet sind.

4. Druckeinrichtung nach einem der Ansprüche 1 bis 3, **dadurch gekennzeichnet,** daß der Druckerbock (10) seitlich vorspringende Lagerzapfen (100, 105) aufweist, die in der Halterung (110) angeordnet sind.

5. Druckeinrichtung nach einem der Ansprüche 1 bis 4, **dadurch gekennzeichnet,** daß der Druckerbock (10) zur Aufnahme von Axialkräften bei Stoßbelastungen in der Halterung (110) elastisch gelagert ist.

6. Druckeinrichtung nach Anspruch 4, **dadurch gekennzeichnet,** daß auf den Lagerzapfen (100, 105) eine Gummihülse (101) angeordnet ist.

7. Druckeinrichtung nach Anspruch 6, **dadurch gekennzeichnet,** daß die Gummihülse (101) einen radial vorspringenden Kranz (104) aufweist.

8. Druckeinrichtung nach einem der Ansprüche 1 bis 5, **dadurch gekennzeichnet,** daß der Druckerbock (10) eine Befestigungsvorrichtung (13, 14) für Leiterplatten (12) aufweist, die mindestens ein Scharniergelenk (13) aufweist, in dem die Leiterplatten (12) schwenkbar angeordnet sind.

9. Druckeinrichtung nach Anspruch 8, **dadurch gekennzeichnet,** daß das Scharniergelenk (13) in dem Druckerbock (10) lösbar befestigt ist.

## Claims

1. Printing apparatus having a housing base (11), a housing top part (15, 16) assigned to the housing base (11), and a separate printer support (10) which accommodates modules of the printing apparatus (1) and is mounted pivotably in a holder (110) arranged on the housing base (11), the housing top part (15, 16) having a housing flap (15), characterized in that the housing flap (15) is arranged pivotably on the housing base (11) independently of the printer support (10), and in that the housing flap (15) supports the printer support (10) when it has been pivoted away from the housing base (11) for assembly and servicing of the printing apparatus (1).

2. Printing apparatus according to Claim 1, characterized in that the printer support (10) has printed-circuit boards (12) which are freely accessible for assembly and servicing of the printing apparatus (1) in the pivoted-away state of the printer support (10).

3. Printing apparatus according to Claim 2, characterized in that the printed-circuit boards (12) are arranged pivotably on the printer support (10).

4. Printing apparatus according to one of Claims 1 to 3, characterized in that the printer support (10) has laterally projecting bearing journals (100, 105) which are arranged in the holder (110).

5. Printing apparatus according to one of Claims 1 to 4, characterized in that the printer support (10) is mounted resiliently in the holder (110) to absorb axial forces in the case of impact loading.

6. Printing apparatus according to Claim 4, characterized in that a rubber sleeve (101) is arranged on the bearing journals (100, 105).

7. Printing apparatus according to Claim 6, characterized in that the rubber sleeve (101) has a radially projecting ring (104).

8. Printing apparatus according to one of Claims 1 to 5, characterized in that the printer support (10) has an attachment device (13, 14) for printed-circuit boards (12), which has at least one hinge (13) in which the printed-circuit boards (12) are pivotably arranged.

9. Printing apparatus according to Claim 8, characterized in that the hinge (13) is attached releasably in the printer support (10).

## Revendications

1. Dispositif d'impression pourvu d'un fond (11) et d'une partie supérieure (15,16) associée au fond (11) du boîtier, et un support séparé d'imprimante (10), qui loge des modules du dispositif d'impression (1) et qui est monté pivotant dans un support (110) disposé sur le fond (11) du boîtier, et dans lequel la partie supérieure (15,16) du boîtier comporte un volet (15), caractérisé par le fait que le volet (15) du boîtier est monté pivotant sur le fond (11) du boîtier indépendamment du support d'imprimante (10) et que le volet (15) du boîtier supporte le support d'imprimante (10) écarté par pivotement, à partir du fond (11) du boîtier, lors du montage et de la maintenance du dispositif d'impression.

2. Dispositif d'impression suivant la revendication 1, caractérisé par le fait que le support d'imprimante (10) possède des plaquettes à circuits imprimés (12), qui sont librement accessibles lors du montage et de la maintenance du dispositif d'impression (1), lorsque le support d'imprimante est à l'état écarté par pivotement.

3. Dispositif d'impression suivant la revendication 2, caractérisé par le fait que les plaquettes à circuits imprimés (12) sont montées pivotantes sur le support d'imprimante (10).

4. Dispositif d'impression suivant l'une des revendications 1 à 3, caractérisé par le fait que le support d'imprimante (10) possède des tourillons (100,105) qui font saillie latéralement et qui sont disposés dans le support (110).

5. Dispositif d'impression suivant l'une des revendications 1 à 4, caractérisé par le fait que le support d'imprimante (10) est supporté élastiquement dans le support (110) d'une manière permettant l'absorption de forces axiales dans le cas de contraintes de choc.

6. Dispositif d'impression suivant la revendication 4, caractérisé par le fait qu'une douille en caoutchouc (101) est disposée sur les tourillons (100,105).

7. Dispositif d'impression suivant la revendication 6, caractérisé par le fait que la douille en caoutchouc (101) possède une couronne (104) qui fait saillie radialement.

8. Dispositif d'impression suivant l'une des revendications 1 à 5, caractérisé par le fait que le support d'impression d'imprimante (10) possède un dispositif de fixation (13,14) pour des plaquettes à circuits imprimés (12), qui possède au moins une articulation formant charnière (13), dans laquelle les plaquettes à circuits imprimés (12) sont montées pivotantes.

9. Dispositif d'impression suivant la revendication 8, caractérisé par le fait que l'articulation formant charnière (13) est fixée de façon amovible dans le support d'imprimante (10).
